# EUROPEAN PATENT SPECIFICATION

(11) **EP 4 607 273 B1**
(45) Date of publication and mention of the grant of the patent: **19.08.2026**
(21) Application number: 24158699.9
(22) Date of filing: 20.02.2024
(51) Int. Cl.: G03F 1/66, G03F 1/82, G03F 7/00, H10P 72/10

(54) **STOCKER SYSTEM FOR STORAGE OF RETICLES,**
LAGERSYSTEM ZUM LAGERN VON PHOTOMASKEN
SYSTÈME DE STOCKAGE POUR STOCKER DES RETICULES

(43) Date of publication of application: 27.08.2025
(73) Proprietor: Brooks Automation (Germany) GmbH, 78256 Steißlingen (DE)
(72) Inventor: Schwetz, Michael, 8400 Winterthur (CH); Schmidt, Alexander, 8203 Schaffhausen (CH)
(74) Representative: Dehns Germany Partnerschaft mbB

(56) References cited:
- EP-A1- 4 258 330
- WO-A1-2023/078589

## Description

The present invention relates to a stocker system for storage of reticles, especially EUV reticles, a corresponding storage stocker and a device for retrieving reticles. The invention further relates to methods for handling reticles.

### Background

Photolithography processes are widely used as one of the key steps in the manufacture of integrated circuits (ICs) and other semiconductor-related devices and/or structures. However, as the dimensions of features produced by such processes decrease, the importance of photolithography for the production of miniature ICs or other devices and/or structures rises.

In photolithography, a geometric pattern is transferred from a photomask (typically referred to as reticle) onto a substrate, for example a semiconductor wafer, by the use of light, a photosensitive layer and a subsequent etching step. Depending on the desired feature size on the substrate, the feature size of the reticle needs to be adapted as well as the wavelength of the light used for pattern transfer, with consideration of the Rayleigh criterion.

In order to reduce the smallest achievable feature size, it has been proposed to use extreme ultraviolet (EUV) radiation. EUV radiation is electromagnetic radiation having a wavelength within the range of 5-20 nm, for example within the range of 5-10 nm.

Any contamination of the reticle may reduce the imaging performance of the photolithographic process and may in more serious cases require the reticle to be replaced. The reticle is typically expensive and therefore any reduction in the frequency with which it must be replaced is advantageous. Furthermore, replacement of the reticle is a time consuming process, during which the photolithographic process may have to be suspended, thereby reducing its efficiency, which is undesirable.

For EUV applications, particle contamination with particle sizes of less than 10 nm as well as chemical contamination, for example by adsorption of volatile organic compounds, can be relevant.

The reticles used for such EUV applications are therefore typically stored in a storage stocker, referred to in the following simply as a stocker, or more generally, as place of storage, and retrieved when needed in connection with the lithography exposure equipment. When they are to be used, reticles are transported, usually within a semiconductor fabrication plant, commonly referred to as a fab or FAB, from such a stocker to process tools. Usually, the reticles are stored in a double shell container (double pod) comprising a so-called EUV outer pod (EOP) and an EUV inner pod (EIP) during transportation as well as for storage within the stocker.

Such a double pod is described in further detail in US 2019/0214287 A1, for example.

Since the acceptable level of particle contamination is extremely low, friction (which leads to abrasion and thus particle generation) of the reticle against the container as well as friction of container components relative to one another needs to be avoided. Therefore, typical EIPs are designed so as to accommodate one reticle in such a way that it has only very limited possibilities to move therein. They are also equipped with an additional reticle retainer configured and adapted to immobilize the reticle inside the EIP. In order to prevent contamination, the EIP is designed to enable a protective gas or vacuum to be applied to the reticle. To that end, typically orifices equipped with filter material are provided for the protective gas to enter from the EOP into the surroundings of the reticle contained in the respective EIP.

The EOP is equipped with an actuator adapted to bias the reticle immobilization means of the EIP into a retaining position, thereby immobilizing the reticle inside the EIP when the EOP is attached to the EIP. The EOP also functions to immobilize the typically two components of the EIP, usually referred to as base plate and cover, against one another to prevent friction induced abrasion.

It is to be understood that the EIP components are moveable against one another as long as they are not immobilized from outside. In order to avoid friction induced abrasion caused by such movement, the EOP conventionally provides such immobilization functionality for the EIP while also providing protection against the surrounding atmosphere, which is necessary e.g. during transport between a storing position and process tools requiring reticles for operation.

EOPs are rather bulky, leading to high space requirements or "footprint" for stockers storing EUV reticles. Furthermore, they are made of polymeric material, which is also prone to abrasion and outgassing of volatile organic compounds.

From WO2023078589A1 there is known a stocker system, in which a plurality of storage pods is used for the storage of reticles. These stocker pods comprise a single pod, a plurality of stocker pods being stackable one upon the other. Compared to storage systems using EIPs and EOPs, this stocker system has significantly lower space requirements.

### Summary of the Invention

The present invention seeks to improve such a stocker system utilising single pods for storage, and provides a stocker system, a storage stocker, and a storage pod according to the respective independent claims.

By designing the alignment features of the stocker pods with the additional functionality of providing a flow of purge gas therethrough, a more compact stocker system can be provided, which has less space requirements than conventional solutions.

The invention provides a highly compact and reliable storage system, as a plurality of storage pods can be safely and reliably stacked directly one above the other, without any storage structures therebetween. At the same time, by means of this direct stacking, ducts extending through all stacked storage pods for individually providing each storage pod with a purge gas and for removing purge gas from each storage pod can be formed. As an effective purge of the interiors of the storage pods can be provided according to the invention, the storage pods can be made of suitable plastics materials, as outgassing effects can effectively be counteracted by the purge gas flowing in the storage pods. The storage pods can also be made of metal materials.

Advantageous embodiments and additional features are provided in the dependent claims and further discussed in the following description.

Advantageously, each storage pod is provided with a first purge gas passageway, which is adapted to provide a purge gas flow from a first alignment feature of its base plate to a first alignment feature of its cover, thereby providing a first duct extending through the stacked configuration, via which purge gas can be provided to each of the storage pods, and wherein each storage pod is provided with a second purge gas passageway, which is adapted to provide a purge gas flow from a second alignment feature of the cover to a second alignment feature of the base plate, thereby providing a second duct extending through the stacked configuration, via which purge gas can be removed from each of the storage pods. Providing such purge gas passageways utilising the alignment features provides a compact and reliable design for stocker systems.

According to a preferred embodiment, each storage pod is provided with a third passageway extending through the cover and essentially vertically to the first and second passageways, a first end of the third passageway communicating with the first passageway, and a second end of the third passageway communicating with the interior space, the third passageway being configured and adapted to provide a purge gas flow from the first passageway to the interior space. By providing a third passageway within the cover, purge gas can reliably be delivered to the interior space of a storage pod. The third passageway can be provided to supply the purge gas at any desired entrance point to the interior space.

Advantageously, each storage pod is provided with a fourth passageway extending through the base plate and essentially vertically to the first and second passageways, a first end of the fourth passageway communicating with the interior space, and a second end of the fourth passageway communicating with the second passageway, the fourth passageway being configured and adapted to provide a purge gas flow from the interior space to the second passageway. Hereby, purge gas can be removed form the interior space in a very effective manner.

Advantageously, any of the passageways can be provided with a particle filter. For example, the second passageway can be provided with a particle filter at its second end, such that only the purge gas can enter the interior of each storage pod. Hereby, individual environments can be provided for each storage pod, such that cross contamination between different storage pods within a stack can be effectively minimised or even avoided.

Advantageously, each storage pod is provided with at least one handling member, such as a handling flange or a handle. Preferably, handling members can be provided on all four sides of a storage pod, such that a handling robot can grip the storage pod at the handling member without the necessity of a rotation of the storage pod. This significantly reduces handling times. Such a handling robot is preferably provided with at least one handling element, also known as an end effector, for handling, i.e. transporting, storage pods.

Expediently, the alignment features configured and adapted to mechanically align adjacent storage pods are provided as pins and/or grooves, wherein the base plate is provided with grooves or pins, and the cover is provided with pins or grooves, wherein grooves and pins are provided for interacting with complementary corresponding pins or grooves provided on adjacent storage pods. Pins and grooves provide very reliable and sturdy alignment features. Such mating grooves and pins especially ensure a precise and exact alignment and positioning of storage pods in the stack. For example, adjacent storage pods stacked one above the other can respectively be provided with interacting pins, preferably dome shaped pins, often referred to as kinematic coupling pins in the technical field, and correspondingly shaped recesses. Hereby, alignment and positioning of storage pods and at the same time a safeguard against horizontal movement of adjacent storage pods can be achieved. This is advantageous to ensure effective handling through handling robots.

Expediently, each storage pod is provided with a mechanism for securing base plate and cover to one another in a releasable manner. For example, each storage pod is provided with a latch mechanism for securing base plate and cover to one another. Such a latch mechanism can comprise a number of latches and ensure a gas tight connection between base plate and cover, these components usually being made of a metal material. Especially, such a latch mechanism is adapted to prevent relative movement of base plate and cover relative to one another in a locked state, thereby preventing abrasion. Also, the latch mechanism can be adapted to immobilise a reticle within a storage pod relative to the storage pod, which also minimises abrasion and contamination effects.

According to a preferred embodiment of the storage stocker comprising a stocker system as outlined above and a storage entity, a securing mechanism adapted to physically secure individual storage pods to one another and/or to the storage entity is provided.

According to a preferred embodiment of the storage pod according to the invention, a first gas passageway is provided, which is adapted to provide a purge gas flow from a first alignment feature of the base plate to a first alignment feature of the cover, and a second gas passageway is provided, which is adapted to provide a purge gas flow from a second alignment feature of the cover to a second alignment feature of the base plate.

Advantageously, a third gas passageway is provided extending through the cover and essentially vertically to the first and second gas passageways, a first end of the third gas passageway communicating with the first gas passageway, and a second end of the third gas passageway communicating with the interior space, the third gas passageway being configured and adapted to provide a purge gas flow from the first gas passageway to the interior space of the storage pod.

Further advantageously, a fourth passageway is provided extending through the base plate and essentially vertically to the first and second gas passageways, a first end of the fourth gas passageway communicating with the interior space, and a second end of the fourth gas passageway communicating with the second gas passageway, the fourth gas passageway being configured and adapted to provide a purge gas flow from the interior space to the second passageway.

Expediently, the second end of the third passageway is configured and adapted such that purge gas flow through the second end impinges essentially vertically on a reticle provided within the interior space, the main extension plane of which extends essentially in parallel to the third and fourth passageways. By providing a vertical impingement of purge gas on the reticle, an especially effective interaction between purge gas and reticle can be ensured, thereby minimising purge gas usage. After impinging on the reticle in this way, the purge gas can then flow around the reticle, essentially in parallel to its main extension planes.

Advantageously, the first opening of each passageway is provided with a particle filter, such that only the purge gas can enter the interior of each storage pod through the first opening. Hereby, individual environments can be provided for each storage pod, such that cross contamination between different storage pods within a stack can be effectively avoided.

Advantageously, each storage pod is provided with at least handling member, which can be gripped, for example, by a handling robot in connection with placement or retrieval of a stocker pod into/from the stacked configuration.

Expediently, each stocker pod is also provided with a mechanism, for example a latch mechanism, for securing base plate and cover to one another in a releasable manner.

Aspects which need to be taken into account when developing such an improved storage concept include that it is highly undesirable to change the way the reticles are provided to the photolithographic process equipment, this typically being the most complicated and costly part of a semiconductor production facility.

### Brief description of the drawings

Advantages and further aspects of the invention will now be discussed further with reference to the appended drawings. Herein,
Figure 1 shows perspective views of a preferred embodiment of two identical storage pods for use in a stocker system according of the invention,
Figure 2 is a schematic side view of a storage pod according to a preferred embodiment of the invention, schematically showing gas passageways provided in the storage pod,
Figure 3 illustrates in greater detail the interaction between alignment features of two adjacent storage pods according to a preferred embodiment of the invention,
Figure 4 shows a perspective view of a preferred embodiment of the base plate and the cover of a stocker pod according to the invention, and
Figure 5 shows a schematic side view of a stacked configuration of stocker pods according to a preferred embodiment of the invention.

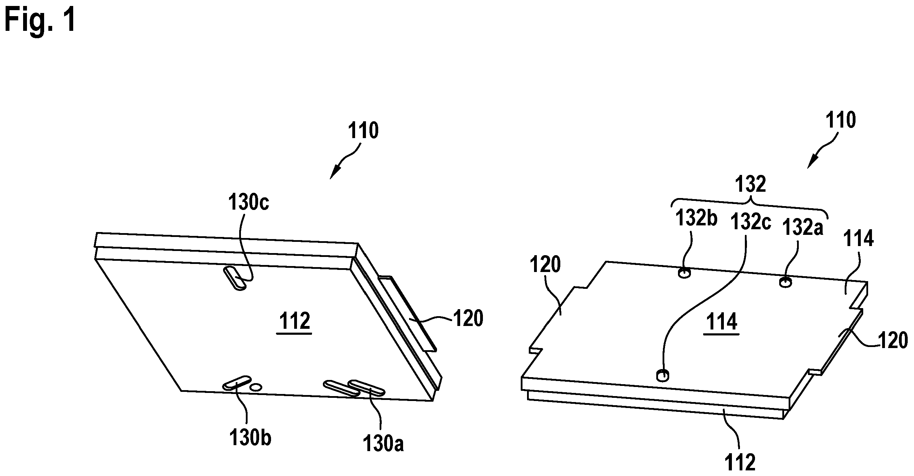

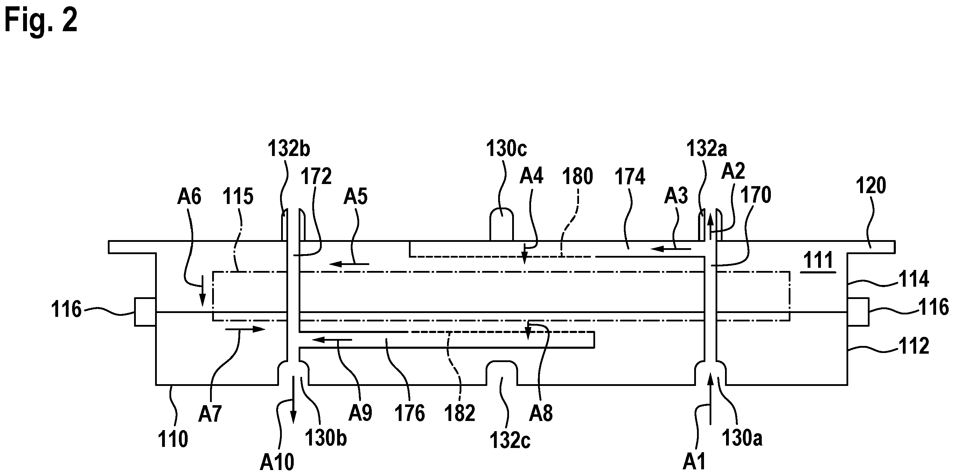

In Figure 1, two storage pods each configured and adapted for storing a reticle within a reticle stocker are designated 110. Each storage pod 110 comprises a base plate 112 and a cover 114. Figure 1 shows the storage pods 110 in their closed state, in which they usually house a reticle (schematically shown in Figure 2 in dot-dashed lines and designated 115). Each storage pod defines an interior space 111, in which reticle 115 is housed, as can especially be seen in Figure 2:
Base plate 112 and cover 114 are held together by a latch mechanism (schematically shown in Figure 2 and designated 116). Typically, the latch mechanism can be provided to define two or three states, a locked state, in which base plate 112 and cover 114 are tightly closed, providing a protected interior (interior space 111) therebetween, an unlocked state, in which base plate 112 and cover 114 can be separated from one another, for example in order to load or unload reticles, and, optionally, an idle state, in which the latches are disabled for usage in or with other tools, for example for cleaning.

The storage pods 110 are provided with a fixing mechanism (also not shown) for fixing a reticle inside the storage pod, when the storage pod is in its closed position, which further minimises potential contamination due to abrasion effects caused by movement of the reticle in the storage pod. Advantageously, the latch mechanism and the fixing mechanism are adapted to cooperate to fix the base plate and the cover relative to one another, as mentioned above, and the reticle relative to the storage pod.

On each side or at least on two opposite sides of storage pod 110, there is provided a handling member 120, such as a handling flange or a handle. Providing handling members on each side enables a handling robot to grip the storage pod 110 from any side, without the necessity of rotating the storage pod. In the embodiment shown, the side handling members are provided on the cover 114. It is also conceivable to provide them on the base plate 112, or for example two on opposite sides of the base plate, and two on different opposite sides of the cover, whereby individual handling of the base plate or the cover by the handling robot is rendered possible or at least simplified.

Base plate 112 and cover 114 of the respective storage pods 110 are advantageously provided with complementary alignment features 130,132 to enable or facilitate their physical or mechanical alignment in a stacked configuration. In the embodiment shown in Figure 1, for example, each base plate 112 is provided with a plurality of grooves 130 formed in its lower side. Each cover is provided with a corresponding plurality of pins (referred to as "kinematic coupling pins") 132 on its upper side. For ease of reference, in case it is expedient to indicate individual grooves or pins in the following, these will also be referred to as grooves 130a, 130b and 130c, as well as pins 132a,132b and 132c respectively.

Alternatively, each base plate could be provided with a plurality of pins, and each cover with a plurality of corresponding grooves. Grooves 130 and pins 132 are formed and positioned to mate with one another such that an exact alignment of the storage pods is provided when they are stacked one above the other. Such an exact alignment is a precondition for effective robot handling by a handling robot. Advantageously, the grooves 130 are provided as elongated holes or slots. Hereby, a relative movement of base plate and cover is effectively avoided, while the remaining sections of grooves 130, i.e. the sections not interacting with the respective pins, can be utilised for other purposes, such as handling purposes.

The dimensions of the storage pods 110, i.e. their size and shape, are preferably fully compatible with existing fully automated EUV pod cleaning equipment.

Some of said alignment features, i.e. pins and grooves 130,132, are configured and adapted to allow a flow of purge gas therethrough, as will be further explained in the following. Figure 2 shows a schematic side view of a storage pod 110. Groove 130a and pin 132a are configured to allow a flow of gas therethrough, such that a first gas passageway 170 is provided between groove 130a of base plate 112 and pin 132a of cover 114. First gas passageway 170 thus extends in a vertical direction through storage pod 110. Further, a vertically extending second gas passageway 172 is provided between a pin 132b of cover 114 and groove 130b of base plate 112, pin 132b and groove 132b also being configured to allow a flow of gas therethrough. Be it noted that groove and pin 130c, 132c are not provided with this functionality of allowing a flow of gas therethrough, so that their only function is an alignment function.

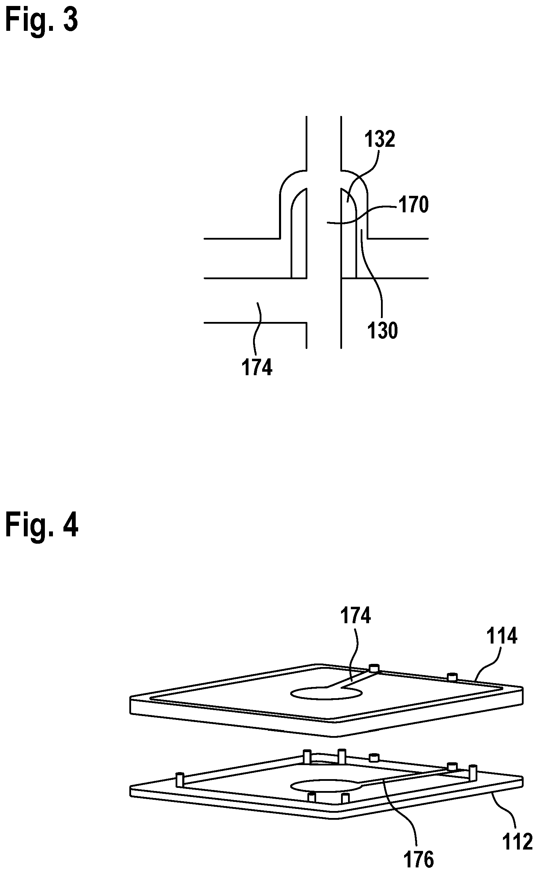

Within an upper side of cover 114 there is provided a third gas passageway 174, a first end of which communicates with the first gas passageway 170, and a second end of which communicates with interior space 111. The second end of third gas passageway 174 is preferably provided with a diameter which is larger than the diameter of the third gas passageway between its first end and its third end. A preferred dimensioning of the third gas passageway is shown in Figure 4. Here, it can be seen that the second end is formed with a circular shape and has a substantially larger diameter that the part of the remaining part of the third gas passageway. Advantageously, at the second end of third gas passageway 174 there is provided a first particle filter 180, which has the same size and shape as the second end, i.e. a circular shape in the embodiment shown in Figure 4.

Within a lower side of the base plate 112 there is provided a fourth gas passageway 176, a first end of which communicates with the interior space 111, and a second end of which communicates with the second gas passageway 172. The first end of fourth gas passageway 176 is advantageously provided with a larger diameter that the remaining part of fourth gas passageway, as also shown in Figure 4. It is preferred that the shape and size of the second end of the third gas passageway 174 corresponds to that of first end of fourth gas passageway.

As indicated by arrows A1 to A10 and explained in the following, this arrangement of first to fourth gas passageways 170,172,174 and 176 provides an effective flow path for purge gas through an individual storage pod as well as through a stacked configuration of storage pods: A purge gas entering the stocker pod 110 through a (not shown) pin of an adjacent storage pod positioned under storage pod 110, the pin mating with groove 130a (arrow A1), flows through the first gas passageway 170 in a vertically upward direction. A first portion of this purge gas exits the stocker pod 110 via pin 132a (arrow A2) and enters the first gas passageway of an adjacent stocker pod (not shown in Figure 2). A second portion of the purge gas flow enters the third gas passageway 174 (arrow A3), and then the interior 111 via first particle filter 180 provided at the second end of the third gas passageway, preferably a PTFE filter, which ensures that non gaseous contaminants contained in the purge gas can not enter the interior space 111. As indicated by arrow A4, this arrangement can ensure that the purge gas essentially impinges reticle 115 at a right angle, which leads to an effective interaction between purge gas and reticle, thus minimising the amount or purge gas required. An enlarged opening at the second end of the third gas passageway, as visible in Figures 2 and 4, provides an efficient and uniform distribution of purge gas to interact with reticle 115.

After impinging on reticle 115, the purge gas flows around reticle 115 as indicated by arrows A6 and A7, and exits the interior space via second particle filter 182 provided at the first end of fourth gas passageway 176, again preferably a PTFE filter (arrow A8). The 2nd particle filter is not required during the normal purge operation. That's true. Provision of this second particle filter 182 is advantageous especially in situation in which the purge gas supply is disabled for any reason. In such cases, there would be a possibility that external air comprising particles could enter the interior space and contaminate a stored reticle. Provision of a second particle filter 182 effectively prevents contamination with particles through the exhaust line in case of a disabled purge gas supply, and also prevents a direct connection between two adjacent pods. Any cross contamination with particles is thereby effectively avoided.

A direct flow of purge gas from the second end of the third gas passageway to the first end of the fourth gas passageway is blocked by reticle 115 positioned therebetween, so that the purge gas is forced to flow around the reticle, as mentioned above. This flow path enables an efficient purging interaction between purge gas and reticle.

The purge gas then flows through fourth gas passageway 176 into the second gas passageway 172, and then exits the storage pod via a (not shown) pin mating with groove 130b, and enters the corresponding second gas passageway 172 of an adjacent storage pod.

By providing a common purge gas supply via first gas passageway 170, and at the same time providing particle filters 180, 182, a highly effective purge gas flow can be individually provided through each storage pod 110 in the stacked configuration. The storage pods 110 thus act as individual storage environments for respective reticles, wherein cross contamination between different storage pods 110 can be effectively avoided. Each storage pod 110 is provided with fresh, uncontaminated purge gas at any time.

The mating of a pin and a groove of adjacent storage pods 110 is shown in further detail in Figure 3. Here, a pin 130 in the cover 114 of a first (lower) stocker pod is shown in mating connection with a groove 132 in the base plate of a second (upper) stocker pod, showing a section of the first gas passageway 170 and of the third gas passageway 174, which branches off from the first gas passageway, as described above.

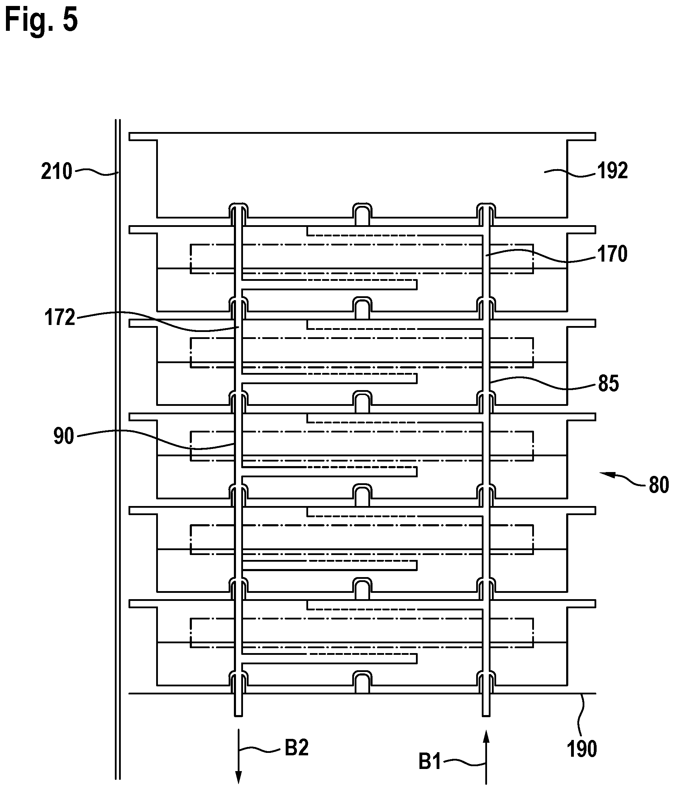

In Figure 5, a storage stocker comprising a preferred embodiment of a stocker system provided in a schematically shown storage entity 210 is shown. The stocker system comprises a stacked configuration 80 of stocker pods, which is shown to further illustrate the general principle of a purge gas flow through the stocker system. The stacked configuration 80 is preferably arranged on a shelf plate (schematically shown and designated 190), which is a part of a storage shelf of a storage entity (not shown). On top of the stacked configuration, a cover plate 192 is preferably provided. Advantageously, in order to stabilize the stacked configuration, especially to prevent damage caused by inadvertent agitation caused for example by an earthquake, there can be provided a securing mechanism, such as a spring mechanism or a clamp mechanism, for securing the storage pods 110 of the stacked configuration to one another, and also for securing the stacked configuration as a whole to the storage entity, for example the shelf plate 190 and/or the storage shelf 192 as mentioned above. Advantageously, storage shelf and/or shelf plate may include alignment features (e.g. pins and/or grooves) complementary to the alignment features 130, 132 of storage pods 110 as discussed above.

As can be seen in Figure 5, purge gas (depicted by arrow B1) from a purge gas supply (not shown) flows vertically upwards through an opening in the shelf plate 190 into a first duct 85 formed by the first gas passageways 170 of the respective storage pods 110 in the stacked configuration 80. The upper end of this first duct 85 is defined by cover plate 192, which blocks a further vertically upward flow of purge gas. As described in detail above, portions of this flow of purge gas are branched off into the individual storage pods 110 via respective third passageways 174 provided in these storage pods. This flow of purge is effected by providing corresponding pressure differences, for example by using pressurised purge gas and/or a ventilator system (both not shown). The removal of purge gas via a second duct 90 formed by second passageways 172 can be enhanced by providing a vacuum suction device (not shown), whereby a fast exchange of purge gas within each storage pod can be provided. As persons skilled in the art will be aware of, preferred purge gases are, for example, Nitrogen or extremely clean dry air (xCDA). This flow of purge gas, via which the purge gas is removed from the stacked configuration 80, is designated by arrow B2.

The flow of purge gas as described above provides a highly efficient utilisation of purge gas. For example, the purge gas exiting the stacked configuration (as depicted by arrow B2) can be collected and recycled, thus reducing the amount of fresh purge gas required for further purging. In prior art solutions, purge gas was not collected in this way after use, but just released into the surrounding atmosphere. Also, the impingement of purge gas onto the reticles in a vertical direction and the subsequent flow of purge gas around the reticles enables an effective cleaning/purging interaction.

## Claims

1. Stocker system for storage of a plurality of reticles, especially EUV reticles, comprising a plurality of storage pods (110), each storage pod (110) comprising a base plate (112) and a cover (114) defining an interior space (111) and each configured and adapted to hold one of said reticles in the interior space (111), the storage pods (110) further being adapted to be stacked vertically one above the other to provide a stacked configuration (80), each storage pod being provided with alignment features (130,132) in its base plate and its cover, the alignment features being configured and adapted to enable mechanical alignment of a storage pod with adjacent storage pods in the stacked configuration (80), **characterized in that**
at least some of the alignment features (130,132) are configured and adapted to allow a flow of purge gas therethrough.

2. Stocker system according to claim 1, wherein each storage pod (110) is provided with a first purge gas passageway (170), which is adapted to provide a purge gas flow from a first alignment feature (130) of the base plate to a first alignment feature (132) of the cover, thereby providing a first duct (85) extending through the stacked configuration (80), via which purge gas can be provided to each of the storage pods (110), and wherein each storage pod (110) is provided with a second purge gas passageway, which is adapted to provide a purge gas flow from a second alignment feature (132) of the cover to a second alignment feature (130) of the base plate, thereby providing a second duct (90) extending through the stacked configuration (80), via which purge gas can be removed from each of the storage pods (110).

3. Stocker system according to claim 2, wherein each storage pod (110) is provided with a third gas passageway (174) extending through the cover (114) and essentially vertically to the first and second gas passageways (170,172), a first end of the third gas passageway communicating with the first gas passageway (170), and a second end of the third gas passageway communicating with the interior space (111), the third gas passageway (174) being configured and adapted to provide a purge gas flow from the first passageway to the interior space (111).

4. Stocker system according to claims 2 or 3 wherein each storage pod (110) is provided with a fourth gas passageway (176) extending through the base plate and essentially vertically to the first and second gas passageways (170,172), a first end of the fourth gas passageway (176) communicating with the interior space (111), and a second end of the fourth gas passageway communicating with the second passageway, the fourth gas passageway (176) being configured and adapted to provide a purge gas flow from the interior space to the second gas passageway (172).

5. Stocker system according to any one of the preceding claims, wherein each storage pod (110) is provided with at least one handling member (120).

6. Stocker system according to any one of the preceding claims, wherein the alignment features (130,132) configured and adapted to mechanically align adjacent storage pods (110) are provided as pins and/or grooves, wherein the base plate (112) is provided with grooves (130) or pins, and the cover (114) is provided with pins (132) or grooves, wherein grooves and pins are provided for interacting with complementary corresponding pins or grooves provided on adjacent storage pods (110).

7. Stocker system according to any one of the preceding claims, wherein each storage pod (110) is provided with a mechanism (116) for securing base plate (112) and cover (114) to one another.

8. Storage stocker comprising a stocker system according to any one of the preceding claims and a storage entity (210) adapted to store the stocker system.

9. Storage stocker according to claim 8, comprising a securing mechanism adapted to physically secure individual storage pods to one another and/or to the storage entity (210).

10. Storage pod configured and adapted to store a reticle within a stocker, comprising a base plate (112) and a cover (114) defining an interior space, wherein a mechanism (116) is provided for holding together base plate (112) and cover (114) in a releasable manner, the storage pod being provided with alignment features (130,132) configured and adapted to enable mechanical alignment with adjacent storage pods in a stacked configuration (80) of storage pods, **characterized in that** at least some of the alignment features being configured and adapted to allow a flow of purge gas therethrough.

11. Storage pod according to claim 10, wherein a first purge gas passageway is provided, which is adapted to provide a purge gas flow from a first alignment feature (130a) of the base plate to a first alignment feature (132a) of the cover, and a second purge gas passageway is provided, which is adapted to provide a purge gas flow from a second alignment feature (132b) of the cover to a second alignment feature (130b) of the base plate.

12. Storage pod according to claim 11, wherein a third gas passageway (174) is provided extending through the cover (114) and essentially vertically to the first and second passageways (170,172), a first end of the third gas passageway (174) communicating with the first gas passageway, and a second end of the third gas passageway communicating with the interior space (111).

13. Storage pod according to claim 11 or 12, wherein a fourth gas passageway (176) is provided extending through the base plate and essentially vertically to the first and second gas passageways (170,172), a first end of the fourth passageway communicating with the interior space, and a second end of the fourth gas passageway communicating with the second gas passageway.

14. Storage pod according to claim 12 or 13, wherein the second end of the third gas passageway (174) is adapted such that purge gas flow through the second end impinges essentially vertically on a reticle provided within the interior space (111), the main extension plane of which extends essentially in parallel to the third and fourth passageways.

## Patentansprüche

1. Stockersystem zur Aufbewahrung einer Vielzahl von Retikeln, insbesondere EUV-Retikeln, umfassend eine Vielzahl von Speicherpods (110), wobei jeder Speicherpod (110) eine Bodenplatte (112) und einen Deckel (114) umfasst, die einen Innenraum (111) definieren, und jeweils dazu konfiguriert und ausgelegt ist, eines der genannten Retikel in dem Innenraum (111) zu halten, wobei die Speicherpods (110) ferner dazu ausgelegt sind, vertikal übereinander gestapelt zu werden, um eine gestapelte Anordnung (80) bereitzustellen, wobei jeder Speicherpod in seiner Bodenplatte und seinem Deckel mit Ausrichtungsmerkmalen (130,132) versehen ist, wobei die Ausrichtungsmerkmale dazu konfiguriert und ausgelegt sind, eine mechanische Ausrichtung eines Speicherpods mit benachbarten Speicherpods in der gestapelten Anordnung (80) zu ermöglichen, **dadurch gekennzeichnet, dass** zumindest einige der Ausrichtungsmerkmale (130,132) dazu konfiguriert und ausgelegt sind, einen Durchfluss von Spülgas bzw. Purgegas durch sie hindurch zu ermöglichen.

2. Stockersystem gemäß Anspruch 1, wobei jeder Speicherpod (110) mit einem ersten Spülgasdurchgang (170) versehen ist, der dazu ausgelegt ist, einen Spülgasstrom von einem ersten Ausrichtungsmerkmal (130) der Bodenplatte zu einem ersten Ausrichtungsmerkmal (132) des Deckels bereitzustellen, wodurch ein erster Kanal (85) bereitgestellt wird, der sich durch die gestapelte Anordnung (80) erstreckt, über den Spülgas jedem der Speicherpods (110) zugeführt werden kann, und wobei jeder Speicherpod (110) mit einem zweiten Spülgasdurchgang versehen ist, der dazu ausgelegt ist, einen Spülgasstrom von einem zweiten Ausrichtungsmerkmal (132) des Deckels zu einem zweiten Ausrichtungsmerkmal (130) der Bodenplatte bereitzustellen, wodurch ein zweiter Kanal (90) bereitgestellt wird, der sich durch die gestapelte Anordnung (80) erstreckt, über den Spülgas aus jedem der Speicherpods (110) abgeführt werden kann.

3. Stockersystem gemäß Anspruch 2, wobei jeder Speicherpod (110) mit einem dritten Gasdurchgang (174) versehen ist, der sich durch den Deckel (114) und im Wesentlichen vertikal zu dem ersten und dem zweiten Gasdurchgang (170,172) erstreckt, wobei ein erstes Ende des dritten Gasdurchgangs mit dem ersten Gasdurchgang (170) in Verbindung steht, und ein zweites Ende des dritten Gasdurchgangs mit dem Innenraum (111) in Verbindung steht, wobei der dritte Gasdurchgang (174) dazu konfiguriert und ausgelegt ist, einen Spülgasstrom von dem ersten Durchgang zu dem Innenraum (111) bereitzustellen.

4. Stockersystem gemäß einem der Ansprüche 2 oder 3, wobei jeder Speicherpod (110) mit einem vierten Gasdurchgang (176) versehen ist, der sich durch die Bodenplatte und im Wesentlichen vertikal zu dem ersten und dem zweiten Gasdurchgang (170,172) erstreckt, wobei ein erstes Ende des vierten Gasdurchgangs (176) mit dem Innenraum (111) in Verbindung steht, und ein zweites Ende des vierten Gasdurchgangs mit dem zweiten Durchgang in Verbindung steht, wobei der vierte Gasdurchgang (176) dazu konfiguriert und ausgelegt ist, einen Spülgasstrom von dem Innenraum zu dem zweiten Gasdurchgang (172) bereitzustellen.

5. Stockersystem gemäß einem der vorstehenden Ansprüche, wobei jeder Speicherpod (110) mit mindestens einem Handhabungselement (120) versehen ist.

6. Stocker system gemäß einem der vorstehenden Ansprüche, wobei die Ausrichtungsmerkmale (130,132), die dazu konfiguriert und ausgelegt sind, benachbarte Speicherpods (110) mechanisch auszurichten, als Stifte und/oder Nuten vorgesehen sind, wobei die Bodenplatte (112) mit Nuten (130) oder Stiften versehen ist, und der Deckel (114) mit Stiften (132) oder Nuten versehen ist, wobei Nuten und Stifte zum Zusammenwirken mit komplementären entsprechenden Stiften oder Nuten vorgesehen sind, die an benachbarten Speicherpods (110) vorgesehen sind.

7. Stockersystem gemäß einem der vorstehenden Ansprüche, wobei jeder Speicherpod (110) mit einem Mechanismus (116) zum Befestigen der Bodenplatte (112) und des Deckels (114) aneinander ausgebildet ist.

8. Speicherstocker, umfassend ein Stockersystem gemäß einem der vorstehenden Ansprüche und eine Speichereinheit (210), die dazu ausgelegt ist, das Stockersystem zu speichern.

9. Speicherstocker gemäß Anspruch 8, umfassend einen Befestigungsmechanismus, der dazu ausgelegt ist, einzelne Speicherpods physisch aneinander und/oder an der Speichereinheit (210) zu befestigen.

10. Speicherpod, der dazu konfiguriert und ausgelegt ist, ein Retikel innerhalb eines Stockers zu speichern, umfassend eine Bodenplatte (112) und einen Deckel (114), die einen Innenraum definieren, wobei ein Mechanismus (116) zum Zusammenhalten von Bodenplatte (112) und Deckel (114) in lösbarer Weise vorgesehen ist, wobei der Speicherpod mit Ausrichtungsmerkmalen (130,132) versehen ist, die dazu konfiguriert und ausgelegt sind, eine mechanische Ausrichtung mit benachbarten Speicherpods in einer gestapelten Anordnung (80) von Speicherpods zu ermöglichen, **dadurch gekennzeichnet, dass** zumindest einige der Ausrichtungsmerkmale dazu konfiguriert und ausgelegt sind, einen Durchfluss von Spülgas durch sie hindurch zu ermöglichen.

11. Speicherpod gemäß Anspruch 10, wobei ein erster Spülgasdurchgang vorgesehen ist, der dazu ausgelegt ist, einen Spülgasstrom von einem ersten Ausrichtungsmerkmal (130a) der Bodenplatte zu einem ersten Ausrichtungsmerkmal (132a) des Deckels bereitzustellen, und ein zweiter Spülgasdurchgang vorgesehen ist, der dazu ausgelegt ist, einen Spülgasstrom von einem zweiten Ausrichtungsmerkmal (132b) des Deckels zu einem zweiten Ausrichtungsmerkmal (130b) der Bodenplatte bereitzustellen.

12. Speicherpod gemäß Anspruch 11, wobei ein dritter Gasdurchgang (174) vorgesehen ist, der sich durch den Deckel (114) erstreckt und im Wesentlichen vertikal zu dem ersten und dem zweiten Durchgang (170,172) verläuft, wobei ein erstes Ende des dritten Gasdurchgangs (174) mit dem ersten Gasdurchgang in Verbindung steht, und ein zweites Ende des dritten Gasdurchgangs mit dem Innenraum (111) in Verbindung steht.

13. Speicherpod gemäß Anspruch 11 oder 12, wobei ein vierter Gasdurchgang (176) vorgesehen ist, der sich durch die Bodenplatte erstreckt und im Wesentlichen vertikal zu dem ersten und dem zweiten Gasdurchgang (170,172) verläuft, wobei ein erstes Ende des vierten Durchgangs mit dem Innenraum in Verbindung steht, und ein zweites Ende des vierten Gasdurchgangs mit dem zweiten Gasdurchgang in Verbindung steht.

14. Speicherpod gemäß Anspruch 12 oder 13, wobei das zweite Ende des dritten Gasdurchgangs (174) so ausgelegt ist, dass der Spülgasstrom durch das zweite Ende im Wesentlichen vertikal auf ein in dem Innenraum (111) vorgesehenes Retikel auftrifft, dessen Haupterstreckungsebene sich im Wesentlichen parallel zu dem dritten und dem vierten Durchgang erstreckt.

## Revendications

1. Système de stockage destiné à stocker une pluralité de réticules, en particulier des réticules EUV, comprenant une pluralité de modules de stockage (110), chaque module de stockage (110) comprenant une plaque de base (112) et un couvercle (114) définissant un espace intérieur (111) et chacun étant configuré et adapté pour contenir l'un desdits réticules dans l'espace intérieur (111), les modules de stockage (110) étant en outre adaptés pour être empilés verticalement les uns au-dessus des autres afin de former une configuration empilée (80), chaque module de stockage étant prévu d'avoir des éléments d'alignement (130, 132) dans sa plaque de base et son couvercle, les éléments d'alignement étant configurés et adaptés pour permettre l'alignement mécanique d'un module de stockage avec les modules de stockage adjacents dans la configuration empilée (80), **caractérisé en ce qu'**au moins certains des éléments d'alignement (130, 132) sont configurés et adaptés pour permettre le passage d'un flux de gaz de purge à travers ceux-ci.

2. Système de stockage selon la revendication 1, dans lequel chaque module de stockage (110) prévoit un premier passage de gaz de purge (170), qui est adapté pour assurer un écoulement de gaz de purge depuis un premier élément d'alignement (130) de la plaque de base vers un premier élément d'alignement (132) du couvercle, formant ainsi un premier conduit (85) s'étendant à travers la configuration empilée (80), par lequel du gaz de purge peut être acheminé vers chacun des modules de stockage (110), et dans lequel chaque module de stockage (110) prévoit un deuxième passage de gaz de purge, qui est adapté pour permettre un écoulement de gaz de purge depuis un deuxième repère d'alignement (132) du couvercle vers un deuxième repère d'alignement (130) de la plaque de base, formant ainsi un deuxième conduit (90) s'étendant à travers la configuration empilée (80), par lequel du gaz de purge peut être évacué de chacun des modules de stockage (110).

3. Système de stockage selon la revendication 2, dans lequel chaque module de stockage (110) est prévu d'un troisième passage de gaz (174) s'étendant à travers le couvercle (114) et essentiellement perpendiculairement aux premier et deuxième passages de gaz (170, 172), une première extrémité du troisième passage de gaz communiquant avec le premier passage de gaz (170), et une deuxième extrémité du troisième passage de gaz communiquant avec l'espace intérieur (111), le troisième passage de gaz (174) étant configuré et adapté pour assurer un écoulement de gaz de purge depuis le premier passage vers l'espace intérieur (111).

4. Système de stockage selon une des revendications 2 et 3,, dans lequel chaque module de stockage (110) prévoit un quatrième passage de gaz (176) s'étendant à travers la plaque de base et essentiellement perpendiculairement aux premier et deuxième passages de gaz (170, 172), une première extrémité du quatrième passage de gaz (176) communiquant avec l'espace intérieur (111), et une deuxième extrémité du quatrième passage de gaz communiquant avec le deuxième passage, le quatrième passage de gaz (176) étant configuré et adapté pour assurer un écoulement de gaz de purge depuis l'espace intérieur vers le deuxième passage de gaz (172).

5. Système de stockage selon l'une quelconque des revendications précédentes, dans lequel chaque module de stockage (110) prévoit au moins un élément de manutention (120).

6. Système de stockage selon l'une quelconque des revendications précédentes, dans lequel les éléments d'alignement (130, 132) configurés et adaptés pour aligner mécaniquement des modules de stockage adjacents (110) se présentent sous la forme de tenons et/ou de rainures, la plaque de base (112) est prévue avec des rainures (130) ou des tenons, et le couvercle (114) est prévu avec des tenons (132) ou des rainures, les rainures et les tenons étant prévus pour interagir avec des rainures ou des tenons complémentaires correspondants prévus sur des modules de stockage adjacents (110).

7. Système de stockage selon l'une quelconque des revendications précédentes, dans lequel chaque module de stockage (110) prévoit un mécanisme (116) destiné à fixer la plaque de base (112) et le couvercle (114) l'un à l'autre.

8. Système de stockage comprenant un système de rangement selon l'une quelconque des revendications précédentes et une entité de stockage (210) adaptée pour stocker le système de rangement.

9. Système de stockage selon la revendication 8, comprenant un mécanisme de fixation adapté pour fixer physiquement les modules de stockage individuels les uns aux autres et/ou à l'unité de stockage (210).

10. Module de stockage configuré et adapté pour stocker un réticule à l'intérieur d'un système de stockage, comprenant une plaque de base (112) et un couvercle (114) définissant un espace intérieur, dans lequel un mécanisme (116) est prévu pour maintenir ensemble la plaque de base (112) , et le couvercle (114) de manière amovible, le module de stockage étant prévu de prévoir des éléments d'alignement (130, 132) configurés et adaptés pour permettre un alignement mécanique avec des modules de stockage adjacents dans une configuration empilée (80) de modules de stockage, **caractérisé en ce qu'**au moins certains des éléments d'alignement sont configurés et adaptés pour permettre un écoulement de gaz de purge à travers ceux-ci.

11. Module de stockage selon la revendication 10, dans lequel un premier passage de gaz de purge est prévu, qui est adapté pour assurer un écoulement de gaz de purge depuis un premier élément d'alignement (130a) de la plaque de base vers un premier élément d'alignement (132a) du couvercle, et un deuxième passage de gaz de purge est prévu, qui est adapté pour permettre un écoulement de gaz de purge depuis un deuxième élément d'alignement (132b) du couvercle vers un deuxième élément d'alignement (130b) de la plaque de base.

12. Conteneur de stockage selon la revendication 11, dans lequel un troisième passage de gaz (174) est prévu, s'étendant à travers le couvercle (114) et essentiellement perpendiculairement aux premier et deuxième passages (170, 172), une première extrémité du troisième passage de gaz (174) communiquant avec le premier passage de gaz, et une deuxième extrémité du troisième passage de gaz communiquant avec l'espace intérieur (111).

13. Conteneur de stockage selon la revendication 11 ou 12, dans lequel un quatrième passage de gaz (176) est prévu, s'étendant à travers la plaque de base et essentiellement perpendiculairement aux premier et deuxième passages de gaz (170, 172), une première extrémité du quatrième passage communiquant avec l'espace intérieur, et une deuxième extrémité du quatrième passage de gaz communiquant avec le deuxième passage de gaz.

14. Conteneur de stockage selon la revendication 12 ou 13, dans lequel la deuxième extrémité du troisième passage de gaz (174) est agencée de telle sorte que le flux de gaz de purge traversant ladite deuxième extrémité vienne frapper sensiblement verticalement un réticule prévu à l'intérieur de l'espace intérieur (111), dont le plan principal d'extension s'étend sensiblement parallèlement aux troisième et quatrième passages.
